# EUROPEAN PATENT SPECIFICATION

(11) **EP 1 481 395 B1**
(45) Date of publication and mention of the grant of the patent: **24.01.2007**
(21) Application number: 03700199.7
(22) Date of filing: 31.01.2003
(51) Int. Cl.: G11B 7/125, H01S 5/06

(54) **CONTROLLING THE TEMPERATURE OF A LASER DIODE IN A DISK DRIVE**
TEMPERATURREGELUNG FÜR EINE LASERDIODE IN EINEM PLATTENLAUFWERK
PROCEDE SERVANT A LA REGULATION DE LA TEMPERATURE D'UNE DIODE LASER DANS UN LECTEUR DE DISQUE

(30) Priority: 25.02.2002 EP 02075740
(43) Date of publication of application: 01.12.2004
(73) Proprietor: Koninklijke Philips Electronics N.V., 5621 BA Eindhoven (NL)
(72) Inventor: VAN DER KALL, Herman, P., NL-5656 AA Eindhoven (NL); VAN BIJNEN, Johannes, H.,, NL-5656 AA Eindhoven (NL)
(74) Representative: Uittenbogaard, Frank
(86) International application number: PCT/IB2003/000327
(87) International publication number: WO 2003/071528

(56) References cited:
- EP-A- 0 910 143
- US-A- 5 233 596
- PATENT ABSTRACTS OF JAPAN vol. 017, no. 536 (P-1620), 27 September 1993 (1993-09-27) & JP 05 144062 A (CANON INC), 11 June 1993 (1993-06-11)
- PATENT ABSTRACTS OF JAPAN vol. 1999, no. 01, 29 January 1999 (1999-01-29) & JP 10 289466 A (MATSUSHITA ELECTRIC IND CO LTD), 27 October 1998 (1998-10-27)
- PATENT ABSTRACTS OF JAPAN vol. 017, no. 706 (E-1483), 22 December 1993 (1993-12-22) & JP 05 243655 A (MITSUBISHI ELECTRIC CORP), 21 September 1993 (1993-09-21)
- PATENT ABSTRACTS OF JAPAN vol. 010, no. 162 (P-466), 10 June 1986 (1986-06-10) & JP 61 016043 A (CANON KK), 24 January 1986 (1986-01-24)
- PATENT ABSTRACTS OF JAPAN vol. 2000, no. 14, 5 March 2001 (2001-03-05) & JP 2000 323785 A (NEC CORP), 24 November 2000 (2000-11-24)

## Description

The present invention relates in general to the field of optical storage, more particularly a device for reading or writing information from or to an optical storage medium, especially an optical disc. As is commonly known, such apparatus comprises a motor for rotating the disc, and a laser device for generating a laser beam scanning the surface of the rotating disc.

During operation, the temperature of the device rises. If the temperature of the laser device becomes too high, the lifetime of the laser device decreases. Therefore, it is desirable to limit the temperature of the laser device.

Thus, an optical disc drive is provided with temperature controlling means which are effective to cool down the laser device, for instance by setting the rotational speed of the disc drive motor to a lower value. This temperature controlling means needs a sensing means for sensing the temperature of the laser device. Japanese patent application 10-117506, publication number 11-312361, describes an optical disc drive wherein the temperature of the interior of the disc drive housing is measured by a separate temperature sensor.

One disadvantage of this known design is the need of having a separate temperature sensor. A further disadvantage is that such separate temperature sensor does not measure the actual temperature of the laser device itself.

An important objective of the present invention is to provide an optical disc drive which is capable of accurately controlling the temperature of the laser device, but which has a simpler design which does not need a separate temperature sensor.

The present invention is based on the understanding that a direct relationship exists between the threshold voltage of the laser device on the one hand and the temperature thereof on the other hand, and further on the understanding that, when the light output is kept substantially constant, the electrical parameters such as voltage and current of the electrical power input to the laser device, necessary to maintain the light output of the laser device at said constant level, depend on the actual value of the threshold voltage of the laser device. Thus, based on this understanding, the present invention proposes to maintain the light output of the laser device at a constant level during normal operation, to take said electrical parameters to represent the temperature of the laser device, and to take temperature controlling steps when the value of at least one of these electrical parameters exceeds a predetermined level.

It is noted that a method according to the preamble of claim 1 is disclosed in US-5.233.596. This document shows that it is known per se that a relationship exists between laser current, laser temperature, and outputted light; or, that a relationship exists between laser current and laser temperature if the light output is kept constant. This document uses this information for setting the laser current during recording, on the basis of the detected temperature during reading. The document does not disclose that it is possible to perform temperature control with this information.

These and other aspects, features and advantages of the present invention will be further explained by the following description of a preferred embodiment of the present invention with reference to the drawings, in which same reference numerals indicate same or similar parts, and in which:
Fig. 1 schematically illustrates an optical disc drive device;
Fig. 2 schematically illustrates a semi-conductor laser;
Fig. 3 schematically illustrates a current/voltage characteristic of a semi-conductor laser;
Fig. 4 is a flow diagram schematically illustrating the operation of temperature control in accordance with the present invention;
Fig. 5 schematically illustrates two semi-conductor lasers being controlled by a common control unit.

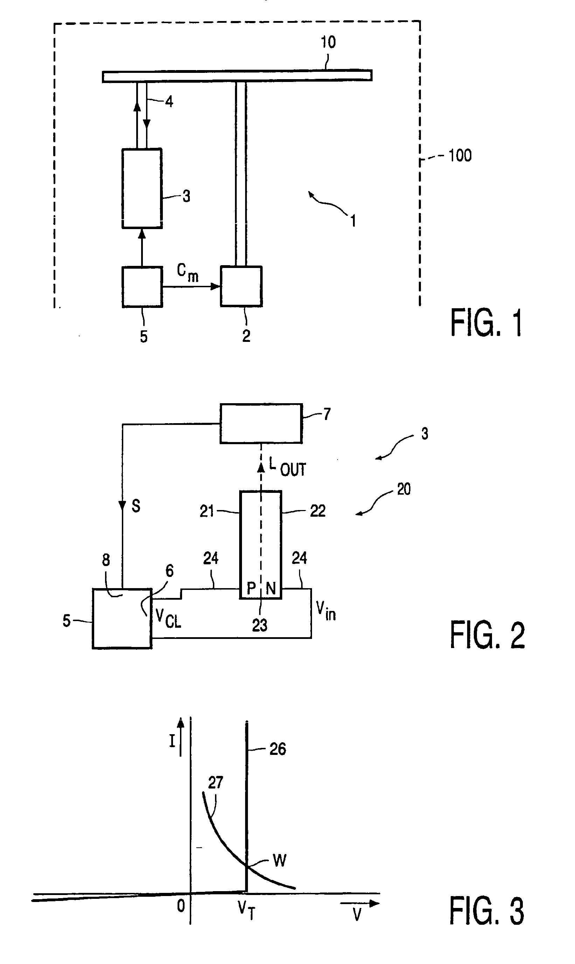

Figure 1 schematically illustrates an optical disc drive device, generally indicated at reference numeral 1. The disc drive 1 comprises means for receiving an optical disc 10, which receiving means are not shown for the sake of simplicity. The disc drive 1 further comprises an electric motor 2 for rotating the disc 10, and a laser device 3 for generating a laser beam 4 directed towards a main surface of the disc 10 and scanning this main surface of the optical disc 10 as the disc rotates. The disc drive 1 further comprises a control unit 5 controlling on the one hand the operation of the laser device 3, and controlling on the other hand the operation of the motor 2. During operation, the motor 2 is controlled to drive the optical disc 10 with a certain predetermined rotational speed.

Typically, said components are arranged within a housing 100. During operation, the temperature in the interior of the housing 100 rises. One of the causes of such temperature rise is the fact that the motor 2 dissipates heat. The amount of heat dissipation is especially a problem at relatively high rotational speeds, such as in the order of 200 Hz.

Figure 2 schematically illustrates an essential component of the laser device 3. The laser device 3 comprises a semi-conductor laser component 20, comprising a P-region 21, an N-region 22, and a PN-junction 23 in between. The laser device 3 further comprises input terminals 24 for receiving an input voltage Vin and applying this input voltage over the PN-junction 23. The semi-conductor laser 20 generates laser light Lout from its PN-junction 23 if an appropriate input voltage Vᵢₙ is applied over said PN-junction 23. Since semi-conductor lasers are commonly known, the operation of such semi-conductor laser 20 will not be explained here in more detail.

Figure 3 schematically illustrates a current/voltage characteristic 26 of a semi-conductor laser 20. The horizontal axis represents the voltage over the PN-junction 23, while the vertical axis represents the current through the PN-junction 23.

As can be seen from figure 3, the semi-conductor laser 20 behaves as a diode: when the voltage is increased from zero, initially virtually no current will flow. Only if the voltage exceeds a certain voltage threshold V_{T}, the current increases exponentially. This threshold voltage V_{T} depends on the actual temperature of the PN-junction 23. Based on this recognition, the present invention proposes to use this threshold voltage V_{T}, which can be determined quite accurately, as a parameter representing the temperature of the PN-junction 23.

One option is to actually measure said threshold voltage V_{T}. However, according to a further elaboration of the invention, this is not necessary. It is easier to measure the electrical parameters of the power input into the semi-conductor laser 20 while keeping the light output L_{OUT} substantially constant, because it has been found that said parameters depend on said threshold voltage V_{T}, hence depend on the temperature, as will be explained hereinafter.

The intensity of the light Lout generated by the semi-conductor laser 20 is substantially proportional to the electrical power input into the semi-conductor laser 20, i.e. the voltage Vᵢₙ over the PN-junction 23 multiplied by the current I through the PN-junction 23. In figure 3, a curve 27 represents the points Vᵢₙ·I = constant (corresponding to L_{OUT} = constant), which curve 27 intersects the laser characteristic 26 in a work point W. When the threshold voltage V_{T} changes, the laser characteristic 26 shifts, and hence a new work point is set when the light intensity L_{OUT} is kept constant. In other words, when the temperature changes, the work point W shifts along the curve 27. Thus, the location of the work point is representative for the temperature. According to the invention, the location of the work point is monitored and, if this location represents a temperature which is considered too high, appropriate temperature reducing steps are taken.

In a practical embodiment, the control unit 5 has an output 6 for supplying a control voltage V_{CL} as an input voltage Vᵢₙ to an input 24 of the semi-conductor laser 20. Further, since it is desirable in the disc drive 1 to maintain the intensity of the laser beam 4 as constant as possible, the disc drive 1 further comprises a light detector 7 arranged to sense the intensity of the laser beam 4 and to generate a detector signal S which is representative of the measured light intensity and which is supplied as an input signal to an input 8 of the control unit 5. Thus, the combination of semi-conductor laser 20 and light detector 7 defines a feedback loop for the control unit 5 as regards its output control signal V_{CL} at its output 6. The control unit 5 is designed to generate its output signal V_{CL} such that the light intensity of the laser beam 4, as signaled by the input signal S at control unit input 8, remains constant. Then, in view of the temperature dependency of the threshold voltage V_{T} of the semi-conductor laser 20, the electrical parameters V_{CL} and I at the output 6 of the control unit 5, being the "coordinates" of the work point W, constitute a direct measure of the temperature of the PN-junction 23. In the following, although the control unit 5 may monitor said electrical parameters V_{CL} and I separately, it will be assumed that the control unit 5 monitors the location of the work point W.

Thus, in principle it would be possible for the control unit 5 to measure the actual temperature of the PN-junction 23 quite accurately. However, such is not necessary for controlling the temperature of the laser device 3. It is sufficient if the control unit 5 is designed to take appropriate action as soon as it finds that the temperature of the laser device 3 reaches a critical temperature value T_{CRIT}. Normally, this predetermined value T_{CRIT} is defined by a manufacturer of the semi-conductor laser device 3. Since the relationship between electrical parameters at output 6 of control unit 5 (i.e. location of work point W) on the one hand and PN-junction 23 temperature on the other hand is a fixed relationship, the critical temperature T_{CRIT} corresponds to a critical work point W_{CRIT}. Thus, the control unit 5 can be designed to take appropriate action when the work point W reaches a predetermined critical work point W_{CRIT}.

As will be clear to a person skilled in the art, the critical work point W_{CRIT} will have critical coordinates V_{CRIT} and I_{CRIT}. Thus, the control unit 5 may be designed to monitor its output voltage V_{CL} and its output current I and, while keeping the light intensity of the laser beam constant, to take appropriate action when either one of its output voltage V_{CL} and its output current I reaches the corresponding critical values V_{CRIT} and I_{CRIT}, respectively.

Said appropriate temperature decreasing action can for instance be: completely switching off the laser device 3; activating a separate cooling unit (not shown); or controlling the motor 2 such that the rotational speed of the motor is reduced. In the latter case, the motor will dissipate less heat, causing the laser device 3 to cool down.

The control unit 5 is further designed to return to normal operating mode when the temperature of the PN-junction 23 has dropped to a sufficiently low level, such as indicated by the work point reaching a second location W_{NORM}.

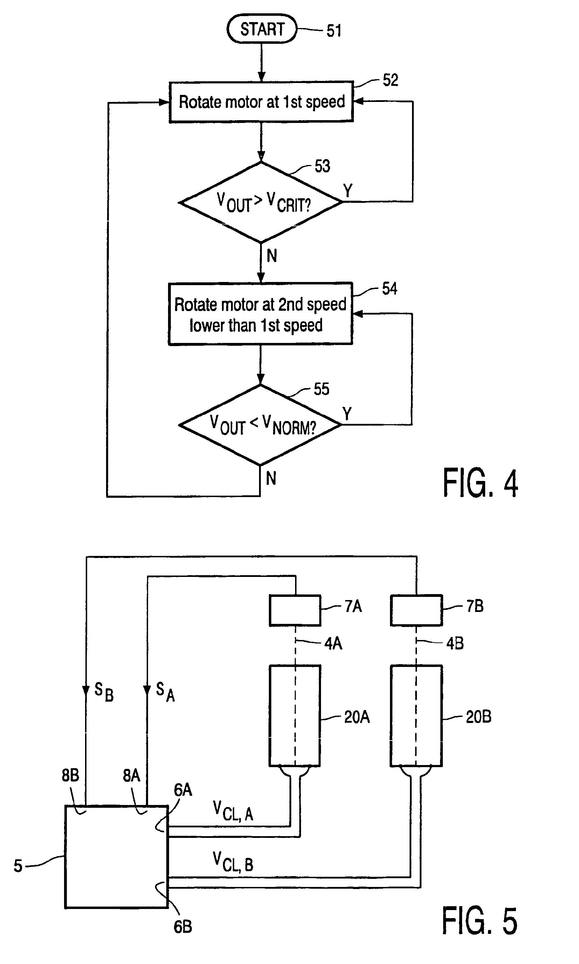

Figure 4 is a flow diagram schematically illustrating the decisions made by the control unit 5 according to a preferred embodiment of the present invention. In the following explanation, for the sake of simplicity, it is assumed that the control unit only monitors its output voltage. However, as mentioned above, the control unit will in fact also monitor its output current.

Following the starting of the disc drive 1 at step 51, the control unit 5 enters a first operative mode wherein the control unit 5 generates a motor control signal Cₘ for the motor 2 such as to rotate the motor at a first rotational speed, as indicated by step 52. This first rotational speed is a relatively high speed, typically higher than 100 Hz, and for instance in the order of 200 Hz.

In the first operative mode, the control unit 5 is designed to continuously monitor its output voltage V_{CL} at its output 6, and to compare this output voltage V_{CL} with a predetermined critical voltage V_{CRIT}, as indicated by step 53. As long as its output voltage V_{CL} is higher than said predetermined critical voltage V_{CRIT}, the control unit 5 remains in the first operative mode, i.e. it continues to supply the motor 2 with said motor control signal Cₘ such as to rotate the motor at said first speed, indicated by step 52.

If the temperature of the PN-junction 23 rises, the threshold voltage V_{T} of the PN-junction 23 decreases. This means that the work point W shifts to the left (figure 3), and the same light intensity is produced by the semi-conductor laser 20 at a lower voltage over the PN-junction 23 and a correspondingly higher current. Thus, during operation, the output voltage V_{CL} of the control unit 5 will decrease. As soon as the control unit 5 finds that its output voltage V_{CL} is equal to or even lower than said predetermined critical voltage V_{CRIT}, the control unit 5 enters a second operative mode in which the temperature of the PN-junction 23 is forced to drop. This second operative mode is indicated as step 54 in figure 4. As mentioned above, this second operative mode may involve the actuation of a cooling device, or switching off the laser 3. However, in this preferred embodiment of the invention, the second operative mode of step 54 involves the generation of a motor control signal Cₘ such that the motor 2 is rotated at a second rotational speed lower than the above-mentioned first rotational speed. In this manner, the motor 2 will generate less heat and, since the motor 2 is the main source of heat generated within the housing 100, the PN-junction 23 of the laser device 3 will gradually cool down.

Even in this second operative mode, the control unit 5 is designed to continuously monitor its output voltage V_{CL}, now comparing it with a second threshold voltage level V_{NORM}, as indicated by step 55. As long as its output voltage V_{CL} is lower than said second threshold voltage level V_{NORM}, the control unit 5 remains in the second operative mode, i.e. it continues to supply the motor 2 with said motor control signal Cₘ such as to rotate the motor at said second speed, indicated by step 54.

When cooling down, the threshold voltage V_{T} of the PN-junction 23 rises, causing the output voltage V_{CL} of the control unit 5 to rise as well. As soon as the control unit 5 finds, in step 55, that its output voltage V_{CL} has reached the second threshold voltage level V_{NORM}, the control unit 5 is designed to move from the second operative mode back to the first operative mode, indicated at step 52, such that the rotational speed of the motor is increased.

In a particular embodiment, a disc drive may comprise two or more semi-conductor lasers 20, for generating a plurality of laser beams 4. This situation, which for instance applies in the case of a DVD player, is schematically illustrated in figure 5, where two semi-conductor lasers 20A and 20B are controlled by a common control unit 5 having corresponding outputs 6A and 6B which supply corresponding control signals V_{CL,A} and V_{CL,B}. Respective intensities of respective laser beams 4A and 4B are measured by respective light detectors 7A and 7B, which supply feedback measuring signals S_{A} and S_{B} to respective inputs 8A and 8B of the common control unit 5. In this case, the control unit 5 is designed to monitor two work points W_{A} and W_{B}, for instance by comparing each output voltage at each output 6A, 6B with a corresponding critical voltage V_{CRIT,A} and V_{CRIT,B}, respectively, keeping in mind that these two critical voltages V_{CRIT,A} and V_{CRIT,B} need not necessarily be identical to each other. Further, the control unit 5 is, in this embodiment, designed to enter its second operative mode with reduced motor speed if at least one of its output voltages V_{CL,A} or V_{CL,B} reaches the corresponding critical voltage V_{CRIT,A} or V_{CRIT,B,} respectively. In the second operative mode, the control unit 5 is designed to compare its output voltages V_{CL,A} and V_{CL,B} with corresponding second voltage threshold levels V_{NORM,A} and V_{NORM,B}, respectively, and to return to the first operative mode if all output voltages have reached the corresponding second threshold levels V_{NORM,A} and V_{NORM,B}. However, in a practical situation, the two (or more) semi-conductor laser devices 20A and 20B may be arranged close to each other, such that their temperatures will virtually be the same, or at least the temperature of one semi-conductor laser may be a good indication of the temperature of the other semi-conductor laser. Thus, in those cases, it suffices if the control unit 5 bases its decision (in step 53) whether or not to move from the first operative mode of step 52 to the second operative mode of step 54, and its decision (in step 55) whether or not to move from its second operative mode of step 54 to its first operative mode of step 52, only on the basis of the comparison of one output voltage with a corresponding critical voltage or a corresponding normal voltage, respectively.

It should be clear to a person skilled in the art that the present invention is not limited to the exemplary embodiments discussed above, but that various variations and modifications are possible within the protective scope of the invention as defined in the appending claims. Primarily, it should be clear to a person skilled in the art that, while in the exemplary embodiments the work point (W) is monitored, the work point (W) is indicative of the laser's threshold voltage (V_{T}), which is affected by temperature changes.

For instance, in the above, it is assumed that the control unit 5 itself performs the steps 53 and 55. However, it is possible that some external unit monitors the output voltage(s) of control unit 5, performs the steps 53 and 55, and sends a command signal to the control unit to force the control unit to the first or the second operational mode.

Further, in the above it is explained that the actual value V_{CL} of the laser input voltage is compared with a certain threshold value. In a preferred embodiment, the laser input voltage is measured at a certain normal temperature, for instance room temperature or normal operating temperature; this measured laser input voltage is taken as zero value V₀. Then during operation, the voltage difference ΔV between the actual value V_{CL} of the laser input voltage and said zero value V₀ (ΔV = V_{CL} - V₀) is taken as indicative for the temperature difference ΔT between the actual temperature and said normal temperature. Thus, during operation, the voltage difference ΔV is compared with a certain threshold to make the decisions of steps 53 and 55.

## Claims

1. Method of operating a disc drive which comprises a semi-conductor laser (20), the method comprising the steps of:
applying electrical power to said semi-conductor laser (20);
measuring a light intensity (Lₒᵤₜ) of a laser beam (4) generated by said semi-conductor laser (20);
controlling said electrical power such that said light intensity (Lₒᵤₜ) remains constant;
measuring at least one electrical parameter (V_{CL}; I) indicative of the work point (W) of said semi-conductor laser (20);
**characterized by** taking temperature reducing steps if the measured value of said at least one electrical parameter (V_{CL}; I) indicates that the operational temperature of the laser device has reached a predetermined critical temperature (T_{CRIT}).

2. Method according to claim 1, wherein a plurality of electrical parameters (V_{CL}; I) indicative of the work point (W) of said semi-conductor laser (20) are measured;
and wherein temperature reducing steps are taken if at least one of said plurality of electrical parameters indicates that the operational temperature of the laser device has reached a predetermined critical temperature (T_{CRIT}).

3. Method according to claim 1 or 2, wherein an electrical parameter (V_{CL}) is compared with a predetermined parameter level (V_{CRIT}; V_{NORM}).

4. Method according to claim 3, wherein said electrical parameter (V_{CL}) is measured at a certain known temperature, this measured value being taken as zero value (V₀);
wherein said electrical parameter (V_{CL}) is measured during operation of the disc drive to yield an actual value (V_{CL});
and wherein the difference (ΔV) between the actual value of said electrical parameter (V_{CL}) and said zero value (V₀) is compared with a predetermined threshold.

5. Method according to any of claims 1-4, wherein said temperature reducing steps comprise, for instance, the step of operating a cooling device or a ventilator, or the step of reducing a clock frequency, or the step of reducing a rotational speed of a motor (2) of said disc drive (1).

6. Method according to claim 5, wherein a rotational speed of a motor (2) of said disc drive (1) is reduced when said electrical parameter (V_{CL}) reaches a first predetermined parameter level (V_{CRIT}) indicative of said semi-conductor laser (20) having reached a predetermined critical temperature (T_{CRIT}), and wherein the rotational speed of said motor (2) of said disc drive (1) is increased when said electrical parameter (V_{CL}) reaches a second predetermined parameter level (V_{NORM}) indicative of said semi-conductor laser (20) having reached a normal temperature.

7. Disc drive (1), comprising:
a disc drive motor (2) for rotating an optical disc (10);
a laser device (3) for generating a laser beam (4);
a control unit (5) controlling the disc drive motor (2) and the laser device (3);
wherein the control unit (5) is designed to monitor at least one electrical parameter (V_{CL}; I) indicative of the work point (W) of a semi-conductor laser (20) of said laser device (3);
**characterized in that** the control unit (5) is designed to take temperature affecting steps in dependency of said at least one electrical parameter (V_{CL}; I).

8. Disc drive according to claim 7, wherein the control unit (5) is designed to control the rotational speed of said disc drive motor (2) in dependency of said at least one electrical parameter (V_{CL}; I).

9. Disc drive according to claim 7 or 8, further comprising:
a light intensity sensor (7) coupled to an input (8) of the control unit (5), disposed to receive at least a portion of the laser beam (4) generated by the semi-conductor laser (20), and designed to generate a measuring signal (S) representative of the light intensity of said laser beam (4);
the control unit (5) being designed to control said semi-conductor laser (20) such as to maintain a constant laser beam intensity.

10. Disc drive according to claim 9, wherein said at least one electrical parameter (V_{CL}; I) comprises an output voltage (V_{CL}) of the control unit (5).

11. Disc drive according to claim 9, wherein said at least one electrical parameter comprises the difference (ΔV) between the actual value of an output voltage (V_{CL}) of the control unit (5) and a zero value (V0) of said output voltage (V_{CL}) of the control unit (5) measured at a certain known temperature.

12. Disc drive according to any of claims 7-11, comprising a plurality of semi-conductor lasers (20A, 20B);
wherein the control unit (5) has a plurality of outputs (6A, 6B) each providing a corresponding control signal (V_{CL,A}; V_{CL,B}) to a corresponding one of said semi-conductor lasers (20A, 20B);
wherein the control unit (5) is designed to monitor a single signal indicative of a work point of only one of said semi-conductor lasers (20A, 20B), and to take temperature affecting steps in dependency of said single threshold voltage indicating signal.

13. Disc drive according to any of the previous claims 7-12, wherein the control unit is designed to perform the method according to any of claims 1-6.

## Patentansprüche

1. Verfahren zum Betreiben eines Plattenlaufwerks, welches einen Halbleiterlaser (20) umfasst, das Verfahren die folgenden Schritte umfassend:
Anlegen von elektrischer Leistung an den Halbleiterlaser (20);
Messen einer Lichtintensität (Lₒᵤₜ) eines Laserstrahls (4), welcher von dem Halbleiterlaser (20) erzeugt wird;
Steuern der elektrischen Leistung, so dass die Lichtintensität (Lₒᵤₜ) konstant bleibt;
Messen mindestens eines elektrischen Parameters (V_{CL}; I), welcher den Arbeitspunkt (W) des Halbleiterlasers (20) bezeichnet;
**gekennzeichnet durch** Unternehmen von Temperaturreduzierungsschritten, falls der gemessene Wert des mindestens einen elektrischen Parameters (V_{CL}; I) angibt, dass die Betriebstemperatur der Laservorrichtung eine vorbestimmte kritische Temperatur (T_{CRIT}) erreicht hat.

2. Verfahren nach Anspruch 1, wobei mehrere elektrische Parameter (V_{CL}; I) gemessen werden, welche den Arbeitspunkt (W) des Halbleiterlasers (20) bezeichnen;
und wobei Temperaturreduzierungsschritte unternommen werden, falls mindestens einer der mehreren elektrischen Parameter angibt, dass die Betriebstemperatur der Laservorrichtung eine vorbestimmte kritische Temperatur (T_{CRIT}) erreicht hat.

3. Verfahren nach Anspruch 1 oder 2, wobei ein elektrischer Parameter (V_{CL}) mit einem vorbestimmten Parameterpegel (V_{CRIT}; V_{NORM}) verglichen wird.

4. Verfahren nach Anspruch 3, wobei der elektrische Parameter (V_{CL}) bei einer bestimmten, bekannten Temperatur gemessen wird, wobei dieser gemessene Wert als Nullwert (V₀) genommen wird;
wobei der elektrische Parameter (V_{CL}) während des Betriebs des Plattenlaufwerks gemessen wird, um einen tatsächlichen Wert (V_{CL}) zu erhalten;
und wobei die Differenz (ΔV) zwischen dem tatsächlichen Wert des elektrischen Parameters (V_{CL}) und dem Nullwert (V₀) mit einer vorbestimmten Schwelle verglichen wird.

5. Verfahren nach einem der Ansprüche 1 bis 4, wobei die Temperaturreduzierungsschritte beispielsweise den Schritt des Betreibens einer Kühlvorrichtung oder eines Ventilators oder den Schritt des Reduzierens einer Taktfrequenz oder den Schritt des Reduzierens einer Drehgeschwindigkeit eines Motors (2) des Plattenlaufwerks (1) umfassen.

6. Verfahren nach Anspruch 5, wobei eine Drehgeschwindigkeit eines Motors (2) des Plattenlaufwerks (1) reduziert wird, wenn der elektrische Parameter (V_{CL}) einen ersten vorbestimmten Parameterpegel (V_{CRIT}) erreicht, welcher dafür bezeichnend ist, dass der Halbleiterlaser (20) eine vorbestimmte kritische Temperatur (T_{CRIT}) erreicht hat, und wobei die Drehgeschwindigkeit des Motors (2) des Plattenlaufwerks (1) erhöht wird, wenn der elektrische Parameter (V_{CL}) einen zweiten vorbestimmten Parameterpegel (VNORM) erreicht, welcher dafür bezeichnend ist, dass der Halbleiterlaser (20) eine normale Temperatur erreicht hat.

7. Plattenlaufwerk (1), umfassend:
einen Plattenlaufwerksmotor (2) zum Drehen einer optischen Platte (10);
eine Laservorrichtung (3) zum Erzeugen eines Laserstrahls (4);
eine Steuerungseinheit (5), welche den Plattenlaufwerksmotor (2) und die Laservorrichtung (3) steuert; wobei die Steuerungseinheit (5) eingerichtet ist, mindestens einen elektrischen Parameter (V_{CL}; I) zu überwachen, welcher den Arbeitspunkt (W) eines Halbleiterlasers (20) der Laservorrichtung (3) angibt;
**dadurch gekennzeichnet, dass** die Steuerungseinheit (5) eingerichtet ist, die Temperatur beeinflussenden Schritte in Abhängigkeit des mindestens einen elektrischen Parameters (V_{CL}; I) zu unternehmen.

8. Plattenlaufwerk nach Anspruch 7, wobei die Steuerungseinheit (5) eingerichtet ist, die Drehgeschwindigkeit des Plattenlaufwerksmotors (2) in Abhängigkeit des mindestens einen elektrischen Parameters (V_{CL}; I) zu steuern.

9. Plattenlaufwerk nach Anspruch 7 oder 8, weiterhin umfassend:
einen Lichtintensitätssensor (7), welcher an einen Eingang (8) der Steuerungseinheit (5) angeschlossen ist, angeordnet um mindestens einen Abschnitt des Laserstrahls (4) zu empfangen, welcher von dem Halbleiterlaser (20) erzeugt wird, und eingerichtet ist, ein Messsignal (S) zu erzeugen, welches für die Lichtintensität des Laserstrahls (4) repräsentativ ist;
wobei die Steuerungseinheit (5) eingerichtet ist, den Halbleiterlaser (20) zu steuern, um eine konstante Laserstrahlintensität zu halten.

10. Plattenlaufwerk nach Anspruch 9, wobei der mindestens eine elektrische Parameter (V_{CL}; I) eine Ausgangsspannung (V_{CL}) der Steuerungseinheit (5) umfasst.

11. Plattenlaufwerk nach Anspruch 9, wobei der mindestens eine elektrische Parameter die Differenz (ΔV) zwischen dem tatsächlichen Wert einer Ausgangsspannung (V_{CL}) der Steuerungseinheit (5) und einem Nullwert (V₀) der Ausgangsspannung (V_{CL}) der Steuerungseinheit (5) umfasst, welcher bei einer bestimmten, bekannten Temperatur gemessen wurde.

12. Plattenlaufwerk nach einem der Ansprüche 7 bis 11, umfassend mehrere Halbleiterlaser (20A, 20B);
wobei die Steuerungseinheit (5) mehrere Ausgänge (6A, 6B) aufweist, welcher jeder ein entsprechendes Steuerungssignal (V_{CL,A}; V_{CL,B}) an einen entsprechenden der Halbleiterlaser (20A, 20B) bereitstellt;
wobei die Steuerungseinheit (5) eingerichtet ist, ein einzelnes Signal zu überwachen, welches einen Arbeitspunkt von nur einem der Halbleiterlaser (20A, 20B) angibt, und die Temperatur beeinflussenden Schritte in Abhängigkeit von dem einzelnen Signal zu unternehmen, welches eine Schwellenspannung angibt.

13. Plattenlaufwerk nach einem der vorhergehenden Ansprüche 7 bis 12, wobei die Steuerungseinheit eingerichtet ist, das Verfahren nach einem der Ansprüche 1 bis 6 durchzuführen.

## Revendications

1. Procédé pour faire fonctionner un entraînement de disque, comprenant un laser à semi-conducteurs (20), le procédé comprenant les étapes pour :
appliquer une alimentation électrique audit laser à semi-conducteurs (20);
mesurer une intensité lumineuse (Lₒᵤₜ) d'un faisceau laser (4) généré par ledit laser à semi-conducteurs (20);
commander ladite alimentation de telle sorte que l'intensité lumineuse (Lₒᵤₜ) demeure coonstante;
mesurer au moins un paramètre électrique (V_{CL};I) qui est une indication du point de travail (W) dudit laser à semi-conducteurs (20);
**caractérisé par le fait que** l'on exécute des étapes de réduction de température si la valeur mesurée d'au moins un paramètre électrique (V_{CL};I) indique que la température de fonctionnement du dispositif de laser a atteint une température critique prédéterminée (T_{CRIT}).

2. Procédé suivant la revendication 1, dans lequel une pluralité de paramètres électriques (V_{CL}; I), qui sont une indication du point de travail (W) dudit laser à semi-conducteurs (20), sont mesurés, et
dans lequel les étapes de réduction de température sont exécutées si au moins un de ladite pluralité de paramètres électriques indique que la température de fonctionnement du dispositif laser a atteint une température critique prédéterminée (T_{CRIT}).

3. Procédé suivant la revendication 1 ou 2, dans lequel un paramètre électrique (V_{CL}) est comparé à un niveau de paramètre prédéterminé (V_{CRIT}, V_{NORM}).

4. Procédé suivant la revendication 3, dans lequel ledit paramètre électrique (V_{CL}) est mesuré à une certaine température connue, cette valeur mesurée étant prise comme valeur nulle (V₀);
dans lequel ledit paramètre électrique (V_{CL}) est mesuré durant le fonctionnement de l'entraînement de disque afin de donner une valeur réelle (V_{CL}), et
dans lequel la différence ΔV entre la valeur réelle dudit paramètre électrique (V_{CL}) et ladite valeur nulle (V₀) est comparée à un seuil prédéterminé.

5. Procédé suivant l'une quelconque des revendications 1 à 4, dans lequel lesdites étapes de réduction de température comprennent par exemple l'étape pour faire fonctionner un dispositif de refroidissement ou un ventilateur, ou l'étape pour réduire une fréquence d'horloge, ou l'étape pour réduire une vitesse de rotation d'un moteur (2) dudit entraînement de disque (1).

6. Procédé suivant la revendication 5, dans lequel une vitesse de rotation d'un moteur (2) dudit entraînement de disque (1) est réduite lorsque ledit paramètre électrique (V_{CL}) atteint un premier niveau de paramètre prédéterminé (V_{CRIT}), qui est une indication dudit laser à semi-conducteurs (20) ayant atteint une température critique prédéterminée (T_{CRIT}), et dans lequel la vitesse de rotation dudit moteur (2) dudit entraînement de disque (1) est augmentée lorsque ledit paramètre électrique (V_{CL}) atteint un second niveau de paramètre prédéterminé (V_{NORM}), qui est une indication dudit dispositif de laser à semi-conducteurs (20) ayant atteint une température normale.

7. Entraînement de disque (1), comprenant :
un moteur d'entraînement de disque (2) destiné à faire tourner un disque optique (10);
un dispositif laser (3) destiné à générer un faisceau laser (4), et
une unité de commande (5) commandant le moteur d'entraînement de disque (2) et le dispositif de laser (3);
dans lequel l'unité de commande (5) est conçue pour surveiller au moins un paramètre électrique (V_{CL}; I), qui est une indication du point de travail (W) d'un laser à semi-conducteurs (20) dudit dispositif à laser (3), et
**caractérisé en ce que** l'unité de commande (5) est conçue pour exécuter les étapes affectant la température en fonction dudit au moins un paramètre électrique (V_{CL}; I).

8. Entraînement de disque suivant la revendication 7, dans lequel l'unité de commande (5) est conçue pour commander la vitesse de rotation dudit moteur d'entraînement de disque (2) en fonction dudit au moins un paramètre électrique (V_{CL}; I).

9. Entraînement de disque suivant la revendication 7 ou 8, comprenant en outre :
un capteur d'intensité lumineuse (7) relié à une entrée (8) de l'unité de commande (5), apte à recevoir au moins une partie du faisceau laser (4) généré par le laser à semi-conducteurs (20), et conçu pour générer un signal de mesure (S) représentatif de l'intensité lumineuse dudit faisceau laser (4);
l'unité de commande (5) étant conçue pour commander ledit laser à semi-conducteurs (20) de manière à maintenir une intensité de faisceau laser constante.

10. Entraînement de disque suivant la revendication 9, dans lequel ledit au moins un paramètre électrique (V_{CL}; I) comprend une tension de sortie (V_{CL}) de l'unité de commande (5).

11. Entraînement de disque suivant la revendication 9, dans lequel ledit au moins un paramètre électrique comprend la différence (ΔV) entre la valeur réelle d'une tension de sortie (V_{CL}) de l'unité de commande (5) et une valeur nulle (V0) de ladite tension de sortie (V_{CL}) de l'unité de commande (5) mesurée à une certaine température connue).

12. Entraînement de disque suivant l'une quelconque des revendications 7 à 11, comprenant une pluralité de lasers à semi-conducteurs (20A, 20B);
dans lequel l'unité de commande (5) comprend une pluralité de sorties (6A, 6B), fournissant chacune un signal de commande correspondant (V_{CL,A}; V_{CL,B}) à un correspondant des lasers à semi-conducteurs (20A, 20B), et
dans lequel l'unité de commande (5) est conçue pour surveiller un signal unique qui est une indication d'un point de travail d'un seul desdits lasers à semi-conducteurs (20A, 20B), et pour exécuter des étapes affectant la température en fonction dudit signal d'indication de tension de seuil unique.

13. Entraînement de disque suivant l'une quelconque des revendications précédentes 7 à 12, dans lequel l'unité de commande est conçue pour exécuter le procédé suivant l'une quelconque des revendications 1 à 6.
